# FASCICULE DE BREVET EUROPEEN

(11) **EP 3 654 534 B1**
(45) Date de publication et mention de la délivrance du brevet: **24.01.2024**
(21) Numéro de dépôt: 19204748.8
(22) Date de dépôt: 23.10.2019
(51) Int. Cl.: H03K 19/00

(54) **CELLULE LOGIQUE CAPACITIVE**
KAPAZITIVE LOGISCHE ZELLE
CAPACITIVE LOGIC CELL

(30) Priorité: 14.11.2018 FR 1871519
(43) Date de publication de la demande: 20.05.2020
(73) Titulaire: Commissariat à l'Energie Atomique et aux Energies Alternatives, 75015 Paris (FR)
(72) Inventeur: FANET, Hervé, 38054 Grenoble cedex 9 (FR); PILLONNET, Gaël, 38054 Grenoble cedex 9 (FR)
(74) Mandataire: Cabinet Beaumont

(56) Documents cités:
- EP-A1- 1 067 692
- EP-A1- 3 182 590
- GALISULTANOV AYRAT ET AL: "Capacitive-Based Adiabatic Logic", 25 mai 2017 (2017-05-25), INTERNATIONAL CONFERENCE ON FINANCIAL CRYPTOGRAPHY AND DATA SECURITY; [LECTURE NOTES IN COMPUTER SCIENCE; LECT.NOTES COMPUTER], SPRINGER, BERLIN, HEIDELBERG, PAGE(S) 52 - 65, XP047447389, ISBN: 978-3-642-17318-9 [extrait le 2017-05-25] * le document en entier *
- PILLONNET G ET AL: "Adiabatic capacitive logic: A paradigm for low-power logic", 2017 IEEE INTERNATIONAL SYMPOSIUM ON CIRCUITS AND SYSTEMS (ISCAS), IEEE, 28 mai 2017 (2017-05-28), pages 1-4, XP033156553, DOI: 10.1109/ISCAS.2017.8050996 [extrait le 2017-09-25]

## Description

### Domaine technique

La présente demande concerne le domaine des circuits électroniques comportant des cellules mettant en oeuvre des fonctions logiques, aussi appelées cellules logiques ou portes logiques. La présente demande vise plus particulièrement des cellules logiques à faible consommation électrique, et un circuit électronique comportant de telles cellules.

### Technique antérieure

Le demandeur a déjà proposé, dans la demande de brevet EP3182590 (B14590 - DD16568), des exemples de réalisation de cellules logiques élémentaires à base de condensateurs à capacité variable et plus particulièrement de condensateurs à capacité variable à commande électromécanique. Ces cellules peuvent être cascadées en série et/ou en parallèle pour mettre en oeuvre des fonctions logiques plus complexes.

PILLONNET G ET AL: "Adiabatic capacitive logic: A paradigm for low-power logic",2017 IEEE INTERNATIONAL SYMPOSIUM ON CIRCUITS AND SYSTEMS (ISCAS), IEEE, 28 mai 2017 divulgue également des cellules logiques adiabatiques élémentaires à base de condensateurs à capacité variable.

L'utilisation de cellules logiques capacitives permet de réaliser des circuits logiques à très faible consommation électrique. En effet, ceci permet d'éliminer les courants de fuite, qui sont un facteur limitant des circuits logiques classiques, et en particulier des circuits logiques réalisés à base de transistors.

Toutefois, une limitation des cellules logiques décrites dans la demande de brevet EP3182590 susmentionnée réside dans la fabrication relativement complexe et/ou dans l'encombrement relativement important des condensateurs à capacité variable.

### Résumé de l'invention

Ainsi, un mode de réalisation prévoit une cellule logique adiabatique, comportant :
- un premier condensateur à capacité fixe connecté entre un noeud d'application d'une tension d'alimentation variable périodique de la cellule et un noeud flottant de fourniture d'un signal logique de sortie de la cellule ; et
- connectée en parallèle du premier condensateur, une association en série d'un deuxième condensateur à capacité fixe et d'un premier élément à résistance variable, le premier élément à résistance variable comportant une électrode de commande connectée à un noeud d'application d'un premier signal logique d'entrée de la cellule.

Selon un mode de réalisation, le premier élément à résistance variable est un élément à variation négative de résistance.

Selon un mode de réalisation, le premier élément à résistance variable est un élément à variation positive de résistance.

Selon un mode de réalisation, le premier élément à résistance variable est un transistor MOS.

Selon un mode de réalisation, le premier élément à résistance variable est un relai électromécanique.

Selon un mode de réalisation, la cellule comporte en outre, connectée en parallèle du premier condensateur, une association en série d'un troisième condensateur et d'un deuxième élément à résistance variable, le deuxième élément à résistance variable comportant une électrode de commande connectée à un noeud d'application d'un deuxième signal logique d'entrée de la cellule.

Selon un mode de réalisation, la cellule comporte en outre un circuit capacitif de maintien connecté entre le noeud d'alimentation et le noeud flottant de la cellule.

Selon un mode de réalisation, le circuit capacitif de maintien comprend une association en série d'un condensateur et d'un élément à résistance variable.

Selon un mode de réalisation, la cellule comporte en outre un circuit de réinitialisation connecté entre le noeud flottant et un noeud d'application d'un potentiel de référence de la cellule.

Selon un mode de réalisation, le circuit de réinitialisation comprend un élément à résistance variable connecté entre le noeud flottant et le noeud d'application d'un potentiel de référence de la cellule.

Selon un mode de réalisation, la cellule comporte en outre :
- un premier condensateur additionnel connecté entre le noeud d'application de la tension d'alimentation de la cellule et un noeud flottant additionnel de fourniture d'un signal logique de sortie complémentaire de la cellule ; et
- connectée en parallèle du premier condensateur additionnel, une association en série d'un deuxième condensateur additionnel et d'un premier élément à résistance variable additionnel, le premier élément à résistance variable additionnel comportant une électrode de commande connectée à un noeud d'application d'un premier signal logique d'entrée complémentaire de la cellule.

Selon un mode de réalisation, la cellule comprend en outre un circuit capacitif de maintien additionnel, le circuit capacitif de maintien additionnel comprenant une association en série d'un condensateur et d'un élément à résistance variable connectée entre le noeud d'alimentation et le noeud flottant additionnel de la cellule.

Selon un mode de réalisation :
- l'élément à résistance variable du circuit capacitif de maintien a une borne de commande connectée au noeud flottant additionnel de la cellule ; et
- l'élément à résistance variable du circuit capacitif de maintien additionnel a une borne de commande connectée au noeud flottant de la cellule.

Selon un mode de réalisation, la cellule comprend en outre un circuit de réinitialisation additionnel, le circuit de réinitialisation additionnel comprenant un élément à résistance variable connecté entre le noeud flottant additionnel de la cellule et le noeud d'application d'un potentiel de référence de la cellule.

Selon un mode de réalisation :
- l'élément à résistance variable du circuit de réinitialisation a une borne de commande connectée au noeud flottant additionnel de la cellule ; et
- l'élément à résistance variable du circuit de réinitialisation additionnel a une borne de commande connectée au noeud flottant de la cellule.

Un autre mode de réalisation prévoit un circuit logique comportant une première cellule logique telle que défini ci-dessus et une deuxième cellule logique telle que définie ci-dessus cascadée en série avec la première cellule, la première cellule ayant son noeud flottant connecté au noeud d'application du premier signal logique d'entrée de la deuxième cellule.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est un schéma électrique d'un exemple d'une logique capacitive selon un mode de réalisation ;
la figure 2 est un chronogramme illustrant un exemple d'un mode de fonctionnement de la cellule de la figure 1 ;
la figure 3 est un schéma électrique d'un autre exemple d'une cellule logique capacitive selon un mode de réalisation ;
la figure 4 est un schéma électrique d'un autre exemple d'une cellule logique capacitive selon un mode de réalisation ;
la figure 5 est un schéma électrique illustrant plus en détail un exemple de réalisation de la cellule logique capacitive de la figure 1.
la figure 6 est un schéma électrique d'un autre exemple d'une cellule logique capacitive selon un mode de réalisation ;
la figure 7 est un schéma électrique d'un autre exemple d'une cellule logique capacitive selon un mode de réalisation ;
la figure 8 est un schéma électrique d'un autre exemple d'une cellule logique capacitive selon un mode de réalisation ; et
la figure 9 est un chronogramme illustrant un autre exemple d'un mode de fonctionnement d'une cellule logique capacitive selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les utilisations qui peuvent être faites des cellules logiques élémentaires décrites n'ont pas été détaillées, les modes de réalisation décrits étant compatibles avec les utilisations usuelles de cellules logiques élémentaires dans des circuits électroniques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

Dans les exemples décrits, les signaux logiques d'entrée et de sortie d'une cellule logique correspondent à des tensions référencées par rapport à un noeud de référence GND de la cellule, dont le niveau détermine la valeur, haute ou basse, du signal logique. Sauf précision contraire, on entend par signal logique un signal ne pouvant prendre que deux valeurs, une valeur haute, correspondant par exemple à une tension proche de la tension d'alimentation de la cellule, ou une valeur basse, correspondant par exemple à une tension proche de 0 V.

On s'intéresse ici plus particulièrement à la réalisation de cellules élémentaires en logique adiabatique capacitive. Dans ce cas, la tension d'alimentation de chaque cellule est une tension variable périodique et les signaux logiques d'entrée et de sortie de chaque cellule correspondent à des tensions variables périodiques dont l'amplitude détermine la valeur, haute ou basse, du signal logique. On parle aussi de logique impulsionnelle ou logique dynamique dans la mesure où les états des signaux logiques ne sont disponibles que pendant une fraction de la période d'un signal d'horloge formé par la tension d'alimentation de la cellule. A titre d'exemple, un signal logique est dit à l'état haut (1 logique) lorsque l'amplitude de la tension correspondante est proche de l'amplitude de la tension d'alimentation de la cellule, par exemple comprise entre 1 et 10 volts, et à l'état bas (0 logique) lorsque l'amplitude de la tension correspondante est proche de 0 V, par exemple inférieure à 0,5 volt.

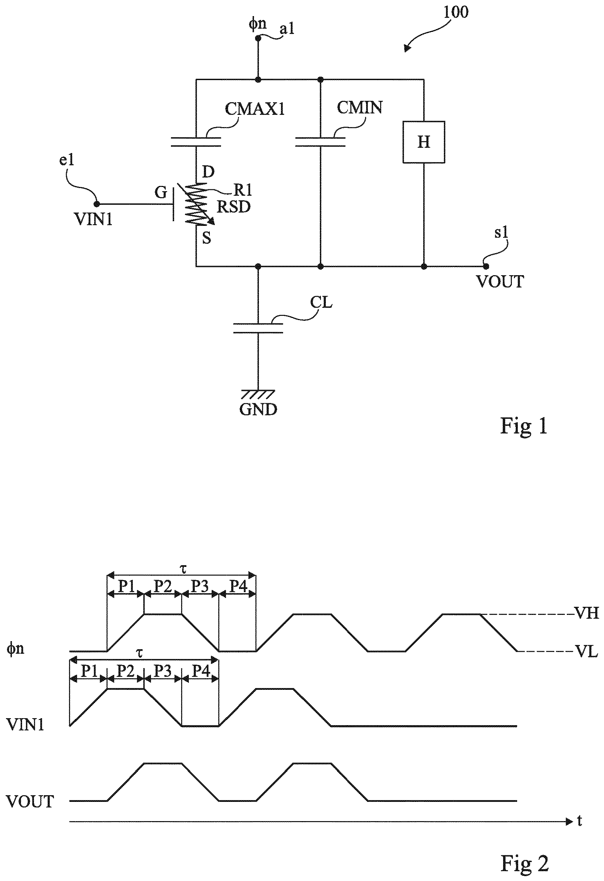

La figure 1 est un schéma électrique d'un exemple d'un mode de réalisation d'une cellule buffer 100 en logique adiabatique capacitive.

La cellule 100 de la figure 1 comprend un premier condensateur CMIN ayant une première électrode reliée, par exemple connectée, à une borne a1 d'application d'une tension d'alimentation φn de la cellule, référencée par rapport à un noeud GND d'application d'un potentiel de référence de la cellule, et une deuxième électrode reliée, par exemple connectée, à une borne s1 de fourniture d'une tension de sortie VOUT de la cellule, référencée par rapport au noeud GND.

La cellule 100 de la figure 1 comprend en outre, en parallèle du condensateur CMIN, entre les bornes a1 et s1 de la cellule, une association en série d'un deuxième condensateur CMAX1 et d'un élément à résistance variable R1. L'élément à résistance variable R1 comprend deux bornes principales de conduction S et D, et au moins une borne de commande G isolée électriquement des bornes principales S et D, adaptée à recevoir un signal de commande pour faire varier la résistance RSD entre ses bornes S et D.

L'élément à résistance variable R1 est par exemple un transistor, par exemple un transistor MOS, les bornes S et D correspondant alors aux bornes de conduction du transistor (par exemple la source et le drain dans le cas d'un transistor MOS) et la borne G correspondant à une borne de commande du transistor (la grille dans le cas d'un transistor MOS). Dans ce cas, le signal de commande appliqué sur la borne G de l'élément R1 est référencé par rapport à la borne principale S ou D de l'élément R1. De préférence, l'élément R1 est un transistor MOS à faible tension de seuil, par exemple présentant une tension de seuil inférieure à 0,1 V, voire une tension de seuil nulle.

A titre de variante, l'élément R1 peut comprendre une deuxième borne de commande (non représentée) aussi appelée borne de commande de référence, isolée électriquement de la borne de commande G et des bornes principales S et D, le signal de commande appliqué sur la borne G de l'élément R1 étant référencé par rapport à la borne de commande de référence. Un exemple de réalisation d'un tel élément est par exemple un relai électromécanique à quatre bornes (deux bornes principales de conduction et deux bornes de commande isolées électriquement l'une de l'autre et des deux bornes principales de conduction).

La borne de commande G de l'élément à résistance variable R1 est reliée, par exemple connectée, à une borne e1 d'application d'une tension d'entrée VIN1 de la cellule, par exemple référencée par rapport au noeud GND.

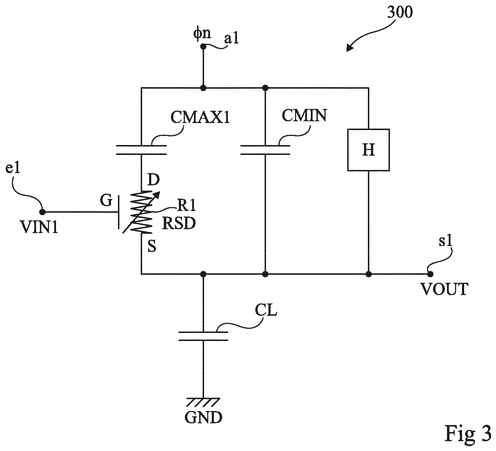

Dans l'exemple de la figure 1, l'élément à résistance variable R1 est un élément à variation négative de résistance, c'est-à-dire que la résistance RSD entre ses bornes principales S et D est une fonction décroissante de la tension appliquée sur son électrode de commande G. Ceci est schématisé par une flèche oblique pointant vers le bas dans la représentation de la figure 1. Les cellules décrites ci-après en relation avec les figures 3 à 8 peuvent également comprendre des éléments à variation positive de résistance, c'est-à-dire dans lesquels la résistance RSD entre les bornes principales S et D est une fonction croissante de la tension appliquée sur l'électrode de commande G. Dans la suite, ces éléments seront schématisés de façon similaire à ce qui a été représenté en figure 1, mais en remplaçant la flèche oblique pointant vers le bas par une flèche oblique pointant vers le haut. A titre d'exemple, un élément à variation négative de résistance peut être constitué par un transistor MOS à canal N et un élément à variation positive de résistance peut être constitué par un transistor MOS à canal P.

Dans la cellule 100, l'élément R1 est relié en série avec le condensateur CMAX1 par ses bornes principales S et D. Plus particulièrement, dans l'exemple représenté, le condensateur CMAX1 a une première électrode reliée, par exemple connectée, à la borne a1 de la cellule et une deuxième électrode reliée, par exemple connectée, à la borne D de l'élément R1, la borne S de l'élément R1 étant reliée, par exemple connectée, à la borne de sortie s1 de la cellule.

Sur la figure 1, un condensateur CL connecté entre la borne de sortie s1 et le noeud de référence GND a été représenté, schématisant la capacité de sortie de la cellule. En pratique, la capacité de sortie CL peut ne pas comprendre de composant spécifiquement réalisé et connecté au noeud de sortie s1, mais correspondre à la somme des capacités des différents éléments reliés au noeud s1, notamment des pistes d'interconnexion, ou encore une autre cellule logique capacitive (non représentée) dont l'entrée peut être reliée au noeud s1. A titre de variante, le condensateur CL peut être un composant spécifiquement ajouté.

La capacité du condensateur CMIN est inférieure à la capacité du condensateur CMAX1. De préférence, la capacité du condensateur CMIN est faible devant la capacité de sortie CL de la cellule, et la capacité du condensateur CMAX1 est élevée devant la capacité CL. A titre d'exemple, la capacité du condensateur CMIN est au moins dix fois plus faible que la capacité CL et la capacité du condensateur CMAX1 est au moins dix fois plus élevée que la capacité CL.

Dans l'exemple de la figure 1, la cellule buffer 100 comprend en outre un circuit de maintien H adapté à maintenir la tension de sortie VOUT de la cellule à un niveau haut lors de phases de transition de la tension d'entrée VIN1 de la cellule d'un niveau haut à un niveau bas.

La figure 2 est un diagramme illustrant le fonctionnement de la cellule buffer 100 de la figure 1. Plus particulièrement, la figure 2 illustre l'évolution, en fonction du temps t (en abscisse), de la tension d'alimentation ou horloge-alimentation φn, de la tension d'entrée VIN1, et de la tension de sortie VOUT de la cellule de la figure 1

La tension d'alimentation φn est une tension variable périodique, fournie par une source de tension variable non représentée en figure 1. La tension φn varie de façon périodique et continue entre une valeur basse VL, par exemple comprise entre 0 et 2 volts, et une valeur haute VH, par exemple supérieure d'au moins 1 volt à la valeur VL. Dans l'exemple représenté, la tension d'alimentation φn est une tension trapézoïdale. Plus particulièrement, dans cet exemple, chaque période τ de la tension φn comprend quatre phases successives P1, P2, P3 et P4 sensiblement de même durée T=τ/4. Lors de la phase P1, la tension φn croit linéairement depuis sa valeur basse VL jusqu'à sa valeur haute VH. Lors de la phase P2, la tension φn reste sensiblement constante et égale à sa valeur haute VH. Lors de la phase P3, la tension φn décroit linéairement depuis sa valeur haute VH jusqu'à sa valeur basse VL. Lors de la phase P4, la tension φn reste sensiblement constante et égale à sa valeur basse VL.

Les tensions VIN1 et VOUT sont synchronisées sur la tension d'alimentation φn, qui sert aussi de signal d'horloge. Les tensions VIN1 et VOUT présentent une variation périodique de forme sensiblement identique à celle de la tension d'alimentation variable φn. Les tensions VIN1 et VOUT définissent respectivement des signaux logiques IN1 et OUT. Le signal logique IN, respectivement OUT, est à un état haut lorsque l'amplitude de la tension variable périodique VIN1, respectivement VOUT, est à un niveau haut, par exemple proche de l'amplitude de la tension d'alimentation φn, et est à un niveau bas lorsque l'amplitude de la tension variable périodique VIN1, respectivement VOUT, est à un niveau bas, par exemple proche de 0 volt. La tension VIN1 présente une avance de phase de l'ordre de T=τ/4 sur la tension d'alimentation φn. La tension VOUT est quant à elle en phase avec la tension d'alimentation φn.

Dans l'exemple représenté en figure 2, le signal d'entrée IN1 est à l'état haut pendant deux périodes τ successives du signal d'alimentation φn, puis passe à l'état bas.

La tension de sortie VOUT dépend du rapport entre la capacité CL et la capacité équivalente de l'association en parallèle du condensateur CMIN et de la branche comprenant le condensateur CMAX1 et l'élément à résistance variable R1. Pour un 0 logique du signal d'entrée IN1 (tension VIN1 d'amplitude proche de 0 volt), la résistance RSD de l'élément R1 est à une valeur haute (correspondant par exemple, dans le cas d'un transistor, à la résistance à l'état bloqué du transistor), de sorte que la capacité équivalente de la cellule entre les bornes a1 et s1 est relativement basse (RSD très inférieure à l'impédance du condensateur CMAX1), par exemple sensiblement égale à la capacité du condensateur CMIN seul (en considérant le temps de montée T=τ/4 de la tension d'alimentation φn comme étant négligeable par rapport à la constante de temps de la branche comportant l'élément R1 et le condensateur CMAX1). L'impulsion de tension VOUT transmise sur la borne de sortie s1 de la cellule est alors à un niveau d'amplitude bas, par exemple proche de 0 volt. Pour un 1 logique du signal d'entrée IN1 (tension VIN1 d'amplitude proche de l'amplitude de la tension d'alimentation φn), la résistance RSD de l'élément R1 diminue jusqu'à une valeur basse (correspondant par exemple, dans le cas d'un transistor, à la résistance à l'état passant du transistor), de sorte que la capacité équivalente de la cellule entre les bornes a1 et s1 augmente jusqu'à une valeur relativement haute (RSD très supérieure à l'impédance du condensateur CMAX1), par exemple sensiblement égale à la capacité du condensateur CMAX1 (en considérant la capacité du condensateur CMIN comme négligeable devant la capacité du condensateur CMAX1). On obtient alors sur la borne de sortie s1 de la cellule une impulsion de tension VOUT présentant un niveau d'amplitude haut, par exemple proche de l'amplitude de la tension d'alimentation φn.

Le circuit de maintien H interne à la cellule buffer permet de maintenir entre les bornes d'alimentation a1 et de sortie s1 de la cellule, pendant la phase de décroissance de l'impulsion de niveau haut de la tension d'entrée VIN1 de la cellule (phase P3 de la tension VIN1, correspondant à la phase P2 de la tension φn), une capacité sensiblement égale à la valeur haute de la capacité équivalente de l'association en parallèle du condensateur CMIN et de la branche comprenant le condensateur CMAX1 et l'élément à résistance variable R1, ce qui permet de fournir en sortie de la cellule une impulsion de niveau haut de même forme (trapézoïdale dans cette exemple) que la tension d'alimentation φn.

Ainsi, la cellule 100 recopie sur sa borne de sortie s1 un signal OUT ayant le même état logique que le signal IN1 appliqué sur sa borne d'entrée e1.

Dans l'exemple décrit ci-dessus d'un fonctionnement à quatre phases, dans un circuit logique comportant plusieurs cellules cascadées en série, chaque cellule reçoit, sur sa borne d'alimentation a1 une tension variable périodique φn en retard de phase d'environ T=τ/4 sur la tension d'alimentation de la cellule précédente. Ceci permet que, dans chaque cellule, le signal logique d'entrée de la cellule (correspondant au signal logique de sortie de la cellule précédente) soit en avance de phase d'environ T=τ/4 sur la tension d'alimentation de la cellule comme illustré en figure 2. Ainsi, dans un circuit logique comportant un nombre supérieur ou égal à 4 de cellules élémentaires cascadées en série, on prévoira quatre tensions d'alimentation φ1, φ2, φ3, φ4 similaires, c'est-à-dire de même fréquence, de même forme et de même niveau d'amplitude, mais déphasées deux à deux d'environ π/2.

En pratique, les tensions d'alimentation trapézoïdales φn peuvent être approximées par des tensions sinusoïdales de période τ.

Un avantage de la cellule buffer 100 de la figure 1 est qu'elle ne comprend pas de condensateur à capacité variable mais uniquement des condensateurs à capacité fixe et un élément à résistance variable. Ces composants peuvent être réalisés relativement aisément et de façon relativement compacte par des méthodes usuelles de réalisation de circuits intégrés, par exemple en technologie CMOS. A titre d'exemple, les condensateurs à capacité fixe CMIN et CMAX1 sont des condensateurs de type métal isolant métal.

Par rapport à des cellules à base de condensateurs à capacité variable du type décrit dans la demande de brevet EP3182590 susmentionnée, l'avantage de réduction des courants de fuite est préservé dans la mesure où il n'existe pas de chemin résistif direct entre la borne d'alimentation a1 et la borne de référence GND de la cellule.

Un autre avantage de la cellule 100 est que l'élément à résistance variable R1 peut être commandé par des tensions plus faibles que les condensateurs à capacité variable des cellules du type décrit dans la demande de brevet EP3182590 susmentionnée. L'amplitude de la tension d'alimentation φn de la cellule peut ainsi être réduite. A titre d'exemple, l'amplitude de la tension d'alimentation φn de la cellule 100 peut être inférieure à 5 V, voire inférieure à 2 V, ce qui permet d'obtenir des circuits logiques à très faible consommation électrique.

La figure 3 est un schéma électrique d'un exemple d'un mode de réalisation d'une cellule inverseuse 300 en logique adiabatique capacitive.

La cellule 300 diffère de la cellule 100 de la figure 1 essentiellement en ce que, dans la cellule 300, l'élément à résistance variable R1 est un élément à variation positive de résistance.

Ainsi, pour un 0 logique du signal d'entrée IN1 (tension VIN1 d'amplitude proche de 0 volt), la résistance RSD de l'élément R1 est à une valeur basse (correspondant par exemple, dans le cas d'un transistor, à la résistance à l'état passant du transistor), de sorte que la capacité équivalente de la cellule entre les bornes a1 et s1 est relativement haute, par exemple sensiblement égale à la capacité du condensateur CMAX1. On obtient alors sur la borne de sortie s1 de la cellule une impulsion de tension VOUT présentant un niveau d'amplitude haut, par exemple proche de l'amplitude de la tension d'alimentation φn. Pour un 1 logique du signal d'entrée IN1 (tension VIN1 d'amplitude proche de l'amplitude de la tension d'alimentation φn), la résistance RSD de l'élément R1 augmente jusqu'à une valeur haute (correspondant par exemple, dans le cas d'un transistor, à la résistance à l'état bloqué du transistor), de sorte que la capacité équivalente de la cellule entre les bornes a1 et s1 diminue jusqu'à une valeur relativement basse, par exemple sensiblement égale à la capacité du condensateur CMIN. L'impulsion de tension VOUT transmise sur la borne de sortie s1 de la cellule est alors à un niveau d'amplitude bas, par exemple proche de 0 V.

Ainsi, la cellule 300 fournit sur sa borne de sortie s1 un signal logique OUT inverse du signal logique IN1 appliqué sur sa borne d'entrée e1.

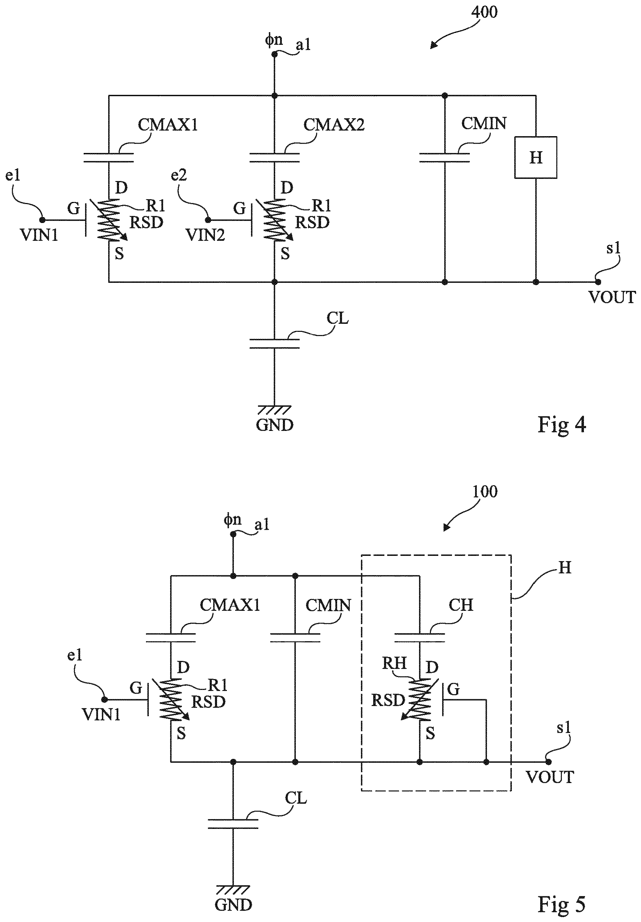

La figure 4 est un schéma électrique d'un exemple d'un mode de réalisation d'une cellule 400 de type ET en logique adiabatique capacitive.

La cellule 400 comprend les mêmes éléments que la cellule 100 de la figure 1, agencés sensiblement de la même manière, et comprend en outre, entre les bornes a1 et s1 de la cellule, en parallèle du condensateur CMIN et de la branche comprenant le condensateur CMAX1 et l'élément R1, une association en série d'un condensateur CMAX2 et d'un élément à résistance variable R2. Le condensateur CMAX2 a par exemple sensiblement la même capacité que le condensateur CMAX1. A titre d'exemple, le condensateur CMAX2 est identique au condensateur CMAX1 aux dispersions de fabrication près. L'élément à résistance variable R2 comprend, comme l'élément R1, deux bornes principales de conduction S et D, et au moins une borne de commande G isolée électriquement de ses bornes principales S et D, adaptée à recevoir un signal de commande pour faire varier la résistance RSD entre ses bornes S et D. Dans cet exemple, l'élément R2 est, comme l'élément R1, un élément à variation négative de résistance. A titre d'exemple, l'élément R2 est identique à l'élément R1 aux dispersions de fabrication près.

La borne de commande G de l'élément à résistance variable R2 est reliée, par exemple connectée, à une borne e2 d'application d'une tension d'entrée VIN2 de la cellule, par exemple référencée par rapport au noeud GND.

Dans la cellule 400, l'élément R2 est relié en série avec le condensateur CMAX2 par ses bornes principales S et D. Plus particulièrement, dans l'exemple représenté, le condensateur CMAX2 a une première électrode reliée, par exemple connectée, à la borne a1 de la cellule et une deuxième électrode reliée, par exemple connectée, à la borne D de l'élément R2, la borne S de l'élément R2 étant reliée, par exemple connectée, à la borne de sortie s1 de la cellule.

La capacité du condensateur CMIN est inférieure à la somme des capacités des condensateurs CMAX1 et CMAX2. A titre d'exemple, la capacité du condensateur CMIN est au moins dix fois plus faible que la somme des capacités des condensateurs CMAX1 et CMAX2. De préférence, la capacité du condensateur CMIN est faible devant la capacité de sortie CL de la cellule, et la somme des capacités des condensateurs CMAX1 et CMAX2 est élevée devant la capacité CL. De plus, de préférence, la somme des capacités des condensateurs CMAX1 et CMIN et la somme des capacités des condensateurs CMAX2 et CMIN sont inférieures à la capacité CL.

Le fonctionnement de la cellule 400 de la figure 4 est similaire à ce qui a été décrit ci-dessus. En particulier, la forme de la tension d'alimentation φn, des tensions d'entrée VIN1 et VIN2 et de la tension de sortie VOUT peuvent être identiques ou similaires à ce qui a été décrit précédemment.

La tension de sortie VOUT dépend du rapport entre la capacité CL et la capacité équivalente de l'association en parallèle du condensateur CMIN, de la branche comprenant le condensateur CMAX1 et l'élément à résistance variable R1, et de la branche comportant le condensateur CMAX2 et l'élément à résistance variable R2. Lorsque les signaux d'entrée IN1 et IN2 sont tous deux à l'état bas (tension VIN1 d'amplitude proche de 0 volt et tension VIN2 d'amplitude proche de 0 volt), la résistance RSD de l'élément R1 et la résistance RSD de l'élément R2 sont toutes deux à une valeur haute, de sorte que la capacité équivalente de la cellule entre les bornes a1 et s1 est relativement basse, par exemple sensiblement égale à la capacité du condensateur CMIN seul. L'impulsion de tension VOUT transmise sur la borne de sortie s1 de la cellule est alors à un niveau d'amplitude bas, par exemple proche de 0 volt. Lorsque les signaux d'entrée IN1 et IN2 sont respectivement à l'état haut et à l'état bas (tension VIN1 d'amplitude proche de l'amplitude de la tension d'alimentation φn et tension VIN2 d'amplitude proche de 0 volt), la résistance RSD de l'élément R1 diminue jusqu'à une valeur basse, de sorte que la capacité équivalente de la cellule entre les bornes a1 et s1 augmente jusqu'à une valeur intermédiaire, par exemple sensiblement égale à la capacité du condensateur CMAX1 en considérant la capacité du condensateur CMIN comme négligeable devant la capacité du condensateur CMAX1. On obtient alors sur la borne de sortie s1 de la cellule une impulsion de tension VOUT présentant un niveau d'amplitude intermédiaire interprété comme un niveau logique bas du signal de sortie. De façon similaire, lorsque les signaux d'entrée IN1 et IN2 sont respectivement à l'état bas et à l'état haut (tension VIN1 d'amplitude proche de 0 volt et tension VIN2 d'amplitude proche de l'amplitude de la tension d'alimentation φn), la résistance RSD de l'élément R2 diminue jusqu'à une valeur basse, de sorte que la capacité équivalente de la cellule entre les bornes a1 et s1 augmente jusqu'à une valeur intermédiaire, par exemple sensiblement égale à la capacité du condensateur CMAX2 en considérant la capacité du condensateur CMIN comme négligeable devant la capacité du condensateur CMAX2. On obtient alors sur la borne de sortie s1 de la cellule une impulsion de tension VOUT présentant un niveau d'amplitude intermédiaire interprété comme un niveau logique bas du signal de sortie. Lorsque les signaux d'entrée IN1 et IN2 sont tous deux à l'état haut (tension VIN1 d'amplitude proche de l'amplitude de la tension d'alimentation φn et tension VIN2 d'amplitude proche de l'amplitude de la tension d'alimentation φn), la résistance RSD de l'élément R1 et la résistance RSD de l'élément R2 diminuent jusqu'à une valeur basse, de sorte que la capacité équivalente de la cellule entre les bornes a1 et s1 augmente jusqu'à une valeur haute, par exemple sensiblement égale à la somme des capacités des condensateurs CMAX1 et CMAX2 en considérant la capacité du condensateur CMIN comme négligeable. On obtient alors sur la borne de sortie s1 de la cellule une impulsion de tension VOUT présentant un niveau d'amplitude haut, par exemple proche de l'amplitude de la tension d'alimentation φn, interprété comme un niveau logique haut du signal de sortie. La cellule 400 réalise donc bien une fonction ET (OUT=IN1.IN2).

A titre de variante, la cellule 400 de la figure 4 peut réaliser une fonction OU en modifiant les capacités des condensateurs CMAX1 et CMAX2.

Plus généralement, diverses fonctions logiques de base, et en particulier les fonctions OU, NON OU et NON ET, peuvent être réalisées en jouant sur l'agencement série et/ou parallèle des condensateurs CMAX1 et CMAX2 et des éléments R1 et R2, et/ou sur le sens de variation (négative ou positive) de la résistance des éléments R1 et/ou R2.

La figure 5 est un schéma électrique illustrant plus en détail un exemple de réalisation de la cellule logique capacitive de la figure 1. La figure 5 reprend les mêmes éléments que la figure 1, et illustre plus en détail un exemple de réalisation du circuit de maintien H de la cellule 100 de la figure 1.

Dans cet exemple, le circuit de maintien H est constitué d'une association en série, entre les bornes a1 et s1 de la cellule, en parallèle du condensateur CMIN et de la branche comprenant le condensateur CMAX1 et l'élément à résistance variable R1, d'un condensateur CH et d'un élément à résistance variable RH.

Le condensateur CH a par exemple sensiblement la même capacité que le condensateur CMAX1. A titre d'exemple, le condensateur CH est identique au condensateur CMAX1 aux dispersions de fabrication près. L'élément à résistance variable RH comprend, comme l'élément R1, deux bornes principales de conduction S et D, et au moins une borne de commande G isolée électriquement de ses bornes principales S et D, adaptée à recevoir un signal de commande pour faire varier la résistance RSD entre ses bornes S et D. Dans cet exemple, l'élément RH est, comme l'élément R1, un élément à variation négative de résistance.

Dans cet exemple, l'élément RH est relié en série avec le condensateur CH par ses bornes principales S et D. Plus particulièrement, dans l'exemple représenté, le condensateur CH a une première électrode reliée, par exemple connectée, à la borne a1 de la cellule et une deuxième électrode reliée, par exemple connectée, à la borne D de l'élément RH, la borne S de l'élément RH étant reliée, par exemple connectée, à la borne de sortie s1 de la cellule. La borne de commande G de l'élément à résistance variable RH est reliée, par exemple connectée, à la borne de sortie s1 de la cellule.

De préférence, l'élément RH est un transistor MOS à faible tension de seuil, par exemple à tension de seuil inférieure à 0,1 V et de préférence nulle, ou un relai électromécanique à quatre bornes, la quatrième borne (ou borne de commande de référence) étant reliée, par exemple connectée, au noeud GND.

Lorsque la tension d'entrée VIN1 revient à sa valeur basse à la suite d'une impulsion de niveau haut (phase P3 de la tension VIN1, correspondant à la phase P2 des tensions φn et VOUT), le condensateur CH se substitue au condensateur CMAX1 pour maintenir la tension VOUT à un niveau haut.

Plus généralement, tout autre circuit permettant de maintenir entre les bornes a1 et s1, pendant la phase de décroissance de l'impulsion de niveau haut de la tension d'entrée VIN1 de la cellule (phase P3 de la tension VIN1), une capacité sensiblement égale à la valeur haute de la capacité équivalente de l'association en parallèle du condensateur CMIN et de la branche comprenant le condensateur CMAX1 et l'élément à résistance variable R1, peut être utilisé en remplacement du circuit H de la figure 5.

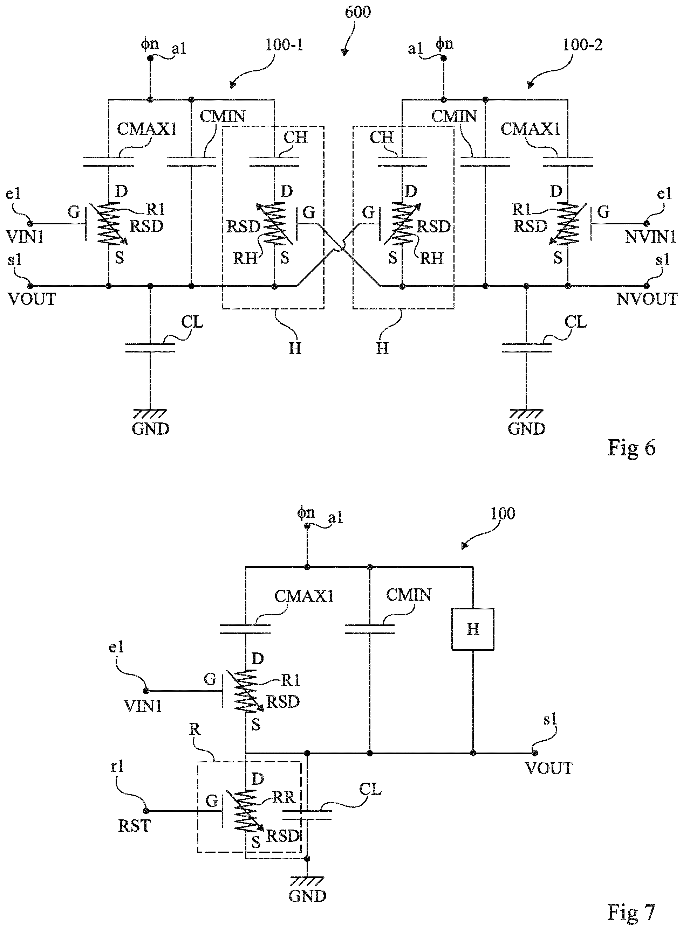

La figure 6 est un schéma électrique d'un autre exemple d'un mode de réalisation d'une cellule élémentaire 600 en logique capacitive adiabatique. La figure 6 illustre plus particulièrement un autre exemple de réalisation de la fonction de maintien, en reliant en parallèle deux cellules logiques identiques recevant des signaux logiques d'entrée complémentaires. Dans l'exemple de la figure 6, la cellule 600 est une cellule buffer/inverseur.

La cellule 600 de la figure 6 comprend deux cellules buffer 100_1 et 100_2. Les cellules 100_1 et 100_2 sont identiques ou similaires à la cellule 100 de la figure 5, à ceci près que :
- dans chacune des cellules 100_1 et 100_2, l'élément à résistance variable RH du circuit de maintien est un élément à variation positive de résistance ;
- dans la cellule 100_1, la borne de commande G de l'élément à résistance variable RH du circuit de maintien H est connectée non pas à la borne de sortie s1 de la cellule 100_1, mais à la borne de sortie s1 de la cellule 100_2 ; et
- dans la cellule 100_2, la borne de commande G de l'élément à résistance variable RH du circuit de maintien H est connectée non pas à la borne de sortie s1 de la cellule 100_2, mais à la borne de sortie s1 de la cellule 100_1.

Les cellules 100_1 et 100_2 reçoivent la même tension d'alimentation φn sur leurs bornes d'alimentation a1 respectives, et ont leurs noeuds GND connectés à un même noeud d'application d'un potentiel de référence. En fonctionnement, la borne d'entrée e1 de la cellule 100_1 reçoit une tension d'entrée VIN1 représentative d'un signal logique d'entrée IN1 de la cellule 600, et la borne d'entrée a1 de la cellule 100_2 reçoit une tension d'entrée NVIN1 représentative d'un signal logique NIN1 complémentaire du signal IN1.

La cellule 600 fournit, sur la borne de sortie s1 de la cellule 100_1, un signal logique OUT (sous la forme d'une tension variable périodique VOUT) ayant le même état logique que le signal IN1, et, sur la borne de sortie s1 de la cellule 100_2, un signal logique NOUT (sous la forme d'une tension variable périodique NVOUT) complémentaire du signal IN1.

La figure 7 est un schéma électrique d'une variante de réalisation de la cellule buffer 100 de la figure 1.

La cellule 100 de la figure 7 comprend les mêmes éléments que dans l'exemple de la figure 1, agencés sensiblement de la même manière, et comprend en outre un circuit de réinitialisation R permettant de réinitialiser à un potentiel de référence le noeud flottant de sortie s1 de la cellule. Dans cet exemple, le circuit de réinitialisation R comprend un élément à résistance variable RR reliant, par ses noeuds de conduction, le noeud de sortie s1 de la cellule au noeud de référence GND de la cellule (en parallèle de la capacité de sortie CL de la cellule). Dans cet exemple, l'élément RR est un élément à variation négative de capacité. L'élément RR est par exemple similaire à l'élément R1. Toutefois, les dimensions de l'élément RR peuvent être différentes de celles de l'élément R1. En pratique, les dimensions de l'élément RR peuvent être inférieures à celles de l'élément R1 dans la mesure où l'élément RR sert uniquement à évacuer d'éventuelles charges électriques résiduelles accumulées sur le noeud s1.

La borne de conduction D de l'élément RR est reliée, par exemple connectée, au noeud de sortie s1 de la cellule, et la borne de conduction S de l'élément RR est reliée, par exemple connectée, au noeud de référence GND de la cellule. La borne de commande G de l'élément RR est reliée, par exemple connectée, à un noeud r1 d'application d'un signal RST de commande en réinitialisation de la cellule.

L'application d'un signal de commande à une valeur basse de la résistance de l'élément RR permet de réinitialiser le noeud de sortie s1 de la cellule sensiblement au potentiel du noeud de référence GND de la cellule. L'application d'un signal de commande à une valeur haute de la résistance de l'élément RR permet d'isoler le noeud de sortie s1 de la cellule du noeud de référence GND. En pratique, un circuit de réinitialisation identique ou similaire peut être prévu dans toutes les cellules logiques capacitives décrites précédemment et en particulier dans les cellules des figures 3, 4, 5 et 6.

Le circuit de réinitialisation R peut être activé à chaque période de l'horloge-alimentation, mais n'est pas nécessairement activé à chaque période de l'horloge-alimentation. Par ailleurs, l'élément RR peut être à activation positive (i.e. l'élément RR est rendu faiblement résistif par application d'un signal RST de niveau haut) ou à activation négative (i.e. l'élément RR est rendu faiblement résistif par application d'un signal RST de niveau bas).

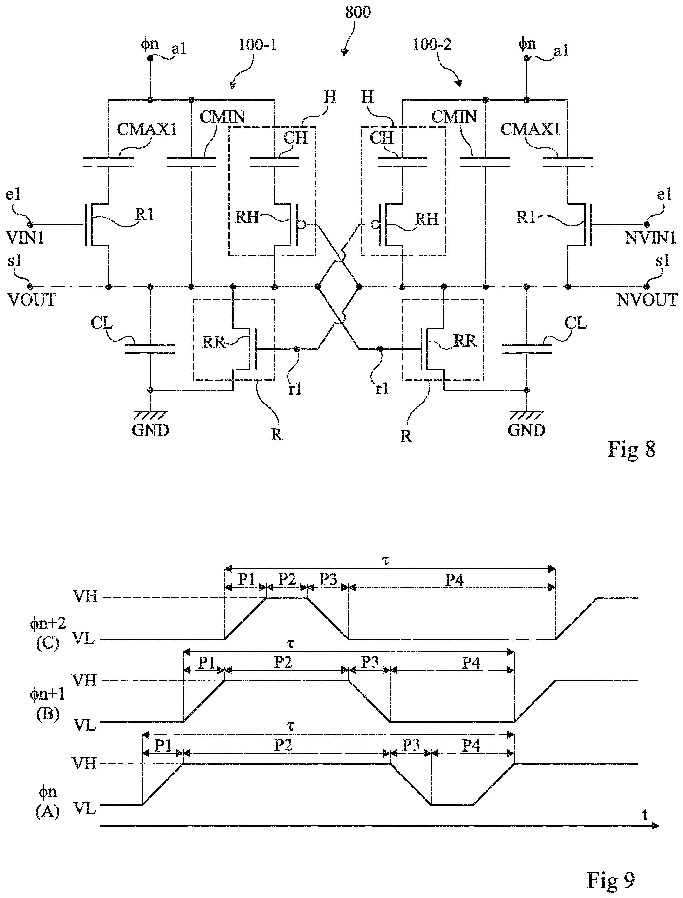

La figure 8 illustre un exemple d'un mode de réalisation d'une cellule élémentaire 800 en logique adiabatique capacitive.

La cellule 800 combine les variantes de réalisation des figures 6 et 7 et utilise des transistors MOS comme éléments à résistance variable. Plus particulièrement, dans l'exemple de la figure 8, les éléments à variation de résistance négative sont des transistors MOS à canal N et les éléments à variation de résistance positive sont des transistors MOS à canal P.

Ainsi, dans chacune des cellules 100_1 et 100_2, l'élément R1 est un transistor MOS à canal N dont la source et le drain sont connectés respectivement au noeud de sortie s1 de la cellule et à une électrode du condensateur CMAX1 de la cellule et dont la grille est connectée au noeud d'entrée e1 de la cellule. De plus, dans chacune des cellules 100_1 et 100_2, l'élément RH est un transistor MOS à canal P dont la source et le drain sont connectés respectivement à une électrode du condensateur CH et au noeud de sortie s1 de la cellule, la grille du transistor RH de la cellule 100_1 étant connectée au noeud de sortie s1 de la cellule 100_2 et la grille du transistor RH de la cellule 100_2 étant connectée au noeud de sortie s1 de la cellule 100_1. En outre, dans chacune des cellules 100_1 et 100_2, l'élément RR est un transistor MOS à canal N dont la source et le drain sont connectés respectivement au noeud de référence GND de la cellule et au noeud de sortie s1 de la cellule, et dont la grille est connectée au noeud de commande r1 du circuit de réinitialisation R de la cellule.

Dans cet exemple, le noeud de commande r1 du circuit de réinitialisation R de la cellule 100_1 est relié, de préférence connecté, au noeud de sortie s1 de la cellule 100_2, et le noeud de commande r1 du circuit de réinitialisation R de la cellule 100_2 est relié, de préférence connecté, au noeud de sortie s1 de la cellule 100_1. Ceci permet que le noeud de sortie s1 de la cellule 100_1 et le noeud de sortie s1 de la cellule 100_2 soient réinitialisés à chaque période du signal d'alimentation φn.

On a décrit ci-dessus des cellules élémentaires pour circuit logique adiabatique capacitif, compatibles avec un mode de fonctionnement du type décrit en relation avec la figure 2, permettant de cascader en série un nombre illimité de cellules en utilisant quatre signaux d'alimentation/horloge φ1, φ2, φ3 et φ4 déphasés deux à deux de 90 degrés. Les modes de réalisation décrits ne se limitent toutefois pas à ce mode de fonctionnement particulier. A titre de variante, on pourra prévoir un circuit logique fonctionnant avec une architecture d'alimentation/horloge dite rétractable, aussi appelée architecture à cadencement de Bennett (Bennett clocking en anglais).

La figure 9 est un chronogramme illustrant un exemple de fonctionnement d'un circuit logique à cadencement de Bennett. On considère dans cet exemple un circuit comprenant trois cellules A, B et C, par exemple du type décrit ci-dessus, cascadées en série. Plus particulièrement, la cellule A, dite de rang n, a une borne de sortie reliée, par exemple connectée, à une borne d'entrée de la cellule B, dite de rang n+1, et la cellule B a une borne de sortie reliée, par exemple connectée, à une borne d'entrée de la cellule C, dite de rang n+2. La cellule A reçoit sur sa borne d'alimentation a1 une tension d'alimentation φn, la cellule B reçoit sur la borne d'alimentation a1 une tension d'alimentation φn+1, et la cellule C reçoit sur sa borne d'alimentation a1 une tension φn+2. Les tensions φn, φn+1 et φn+2 sont représentées sur la figure 9.

Chacune des tensions φn, φn+1 et φn+2 varie de façon périodique entre une valeur basse VL et une valeur haute VH. Comme cela apparaît sur la figure 9, les tensions φn, φn+1 et φn+2 ont sensiblement la même période τ. Toutefois, les tensions φn, φn+1 et φn+2 n'ont pas le même rapport cyclique. Dans cet exemple, le temps de montée de la valeur basse VL à la valeur haute VH (phase P1) et le temps de descente de la valeur haute VH à la valeur basse VL (phase P3) est sensiblement le même pour chacune des tensions φn, φn+1 et φn+2. Toutefois, le temps de maintien au niveau haut VH de la tension d'alimentation (phase P2) est plus élevé pour la tension φn que pour la tension φn+1 et est plus élevé pour la tension φn+1 que pour la tension φn+2. Plus particulièrement, la phase P2 de la tension φn commence au début de la phase P1 de la tension φn+1 et se termine à la fin de la phase P3 de la tension φn+1, et la phase P2 de la tension φn+1 commence au début de la phase P1 de la tension φn+2 et se termine à la fin de la phase P3 de la tension φn+2. A l'inverse, le temps de maintien au niveau bas VL de la tension d'alimentation (phase P4) est plus faible pour la tension φn que pour la tension φn+1 et est plus faible pour la tension φn+1 que pour la tension φn+2. Plus particulièrement, la phase P4 de la tension φn+2 commence au début de la phase P3 de la tension φn+1 et se termine à la fin de la phase P1 suivante de la tension φn+1, et la phase P4 de la tension φn+1 commence au début de la phase P3 de la tension φn et se termine à la fin de la phase P1 suivante de la tension φn.

Dans ce mode de fonctionnement, le nombre de cellules logiques pouvant être cascadées en série est limité par le nombre de tensions d'alimentation φn imbriquées disponibles. Toutefois, un avantage est que les circuits de maintien H des cellules logiques décrites précédemment peuvent être omis.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, bien que l'on ait décrit ci-dessus uniquement des exemples de réalisation basés sur des signaux logiques à deux états, les modes de réalisation décrits peuvent être adaptés à la mise en oeuvre d'une logique multi-niveau, c'est-à-dire dans laquelle les signaux de données peuvent prendre un nombre d'états discrets supérieur à 2. Pour cela, on pourra ajouter d'autres condensateurs à capacité fixe et d'autres éléments à résistance variable pour moduler le rapport capacitif entre la capacité CL et la capacité équivalente entre les noeuds d'alimentation a1 et de sortie s1 des cellules sur un nombre de niveaux supérieur à 2. Les différents éléments à résistance variable d'une même cellule logique pourront alors avoir des tensions de basculement différentes.

## Revendications

1. Cellule logique adiabatique (100 ; 300 ; 400 ; 600 ; 800), comportant :
- un premier condensateur (CMIN) à capacité fixe connecté entre un noeud (a1) d'application d'une tension d'alimentation variable périodique (φn) de la cellule et un noeud flottant (s1) de fourniture d'un signal logique de sortie (VOUT) de la cellule ; et
- connectée en parallèle du premier condensateur (CMIN), une association en série d'un deuxième condensateur (CMAX1) à capacité fixe et d'un premier élément à résistance variable (R1), le premier élément à résistance variable (R1) comportant une électrode de commande (G) connectée à un noeud (e1) d'application d'un premier signal logique d'entrée (VIN1) de la cellule.

2. Cellule logique (100 ; 400 ; 600 ; 800) selon la revendication 1, dans laquelle le premier élément à résistance variable (R1) est un élément à variation négative de résistance.

3. Cellule logique (300) selon la revendication 1, dans laquelle le premier élément à résistance variable (R1) est un élément à variation positive de résistance.

4. Cellule logique (100 ; 300 ; 400 ; 600 ; 800) selon l'une quelconque des revendications 1 à 3, dans laquelle le premier élément à résistance variable (R1) est un transistor MOS.

5. Cellule logique (100 ; 300 ; 400 ; 600) selon l'une quelconque des revendications 1 à 3, dans laquelle le premier élément à résistance variable (R1) est un relai électromécanique.

6. Cellule logique (400) selon l'une quelconque des revendications 1 à 5, comportant en outre, connectée en parallèle du premier condensateur (CMIN), une association en série d'un troisième condensateur (CMAX2) et d'un deuxième élément à résistance variable (R2), le deuxième élément à résistance variable (R2) comportant une électrode de commande (G) connectée à un noeud (e2) d'application d'un deuxième signal logique d'entrée (VIN2) de la cellule.

7. Cellule logique (100 ; 300 ; 400 ; 600 ; 800) selon l'une quelconque des revendications 1 à 6, comportant en outre un circuit capacitif de maintien (H) connecté entre le noeud d'alimentation (a1) et le noeud flottant (s1) de la cellule.

8. Cellule logique (100 ; 300 ; 400 ; 600 ; 800) selon la revendication 7, dans laquelle le circuit capacitif de maintien (H) comprend une association en série d'un condensateur (CH) et d'un élément à résistance variable (RH) .

9. Cellule logique (100 ; 300 ; 400 ; 600 ; 800) selon l'une quelconque des revendications 1 à 8, comportant en outre un circuit de réinitialisation (R) connecté entre le noeud flottant (s1) et un noeud (GND) d'application d'un potentiel de référence de la cellule.

10. Cellule logique (100 ; 300 ; 400 ; 600 ; 800) selon la revendication 9, dans laquelle le circuit de réinitialisation (R) comprend un élément à résistance variable (RR) connecté entre le noeud flottant (s1) et le noeud d'application d'un potentiel de référence (GND) de la cellule.

11. Cellule logique (600 ; 800) selon l'une quelconque des revendications 1 à 10, comportant en outre :
- un premier condensateur additionnel (CMIN) connecté entre le noeud (a1) d'application de la tension d'alimentation (φn) de la cellule et un noeud flottant additionnel (s1) de fourniture d'un signal logique de sortie complémentaire (NVOUT) de la cellule ; et
- connectée en parallèle du premier condensateur additionnel (CMIN), une association en série d'un deuxième condensateur additionnel (CMAX1) et d'un premier élément à résistance variable additionnel (R1), le premier élément à résistance variable additionnel (R1) comportant une électrode de commande (G) connectée à un noeud (e1) d'application d'un premier signal logique d'entrée complémentaire (NVIN1) de la cellule.

12. Cellule logique (600 ; 800) selon la revendication 11, comprenant en outre un circuit capacitif de maintien additionnel (H), le circuit capacitif de maintien additionnel (H) comprenant une association en série d'un condensateur (CH) et d'un élément à résistance variable (RH) connectée entre le noeud d'alimentation (a1) et le noeud flottant additionnel (s1) de la cellule.

13. Cellule logique (600 ; 800) selon la revendication 12 dans son rattachement à la revendication 8, dans laquelle :
- l'élément à résistance variable (RH) du circuit capacitif de maintien a une borne de commande (G) connectée au noeud flottant additionnel (s1) de la cellule ; et
- l'élément à résistance variable (RH) du circuit capacitif de maintien additionnel a une borne de commande (G) connectée au noeud flottant (s1) de la cellule.

14. Cellule logique (800) selon l'une quelconque des revendications 11 à 13, comprenant en outre un circuit de réinitialisation additionnel (R), le circuit de réinitialisation additionnel (R) comprenant un élément à résistance variable (RR) connecté entre le noeud flottant additionnel (s1) de la cellule et le noeud (GND) d'application d'un potentiel de référence de la cellule.

15. Cellule logique (800) selon la revendication 14 dans son rattachement à la revendication 10, dans laquelle :
- l'élément à résistance variable (RH) du circuit de réinitialisation (R) a une borne de commande (G) connectée au noeud flottant additionnel (s1) de la cellule ; et
- l'élément à résistance variable (RH) du circuit de réinitialisation additionnel (R) a une borne de commande (G) connectée au noeud flottant (s1) de la cellule.

16. Circuit logique comportant une première cellule logique (100 ; 300 ; 400 ; 600 ; 800) selon l'une quelconque des revendications 1 à 15 et une deuxième cellule logique (100 ; 300 ; 400 ; 600 ; 800) selon l'une quelconque des revendications 1 à 15 cascadée en série avec la première cellule, la première cellule ayant son noeud flottant (s1) connecté au noeud (e1) d'application du premier signal logique d'entrée de la deuxième cellule.

## Patentansprüche

1. Adiabatische Logikzelle (100; 300; 400; 600; 800), die Folgendes aufweist
- einen ersten Kondensator (CMIN) mit fester Kapazität, der zwischen einem Knoten (a1) zum Anlegen einer variablen periodischen Versorgungsspannung (Φn) der Zelle und einem potentialfreien Knoten (s1) zum Bereitstellen eines logischen Ausgangssignals (VOUT) der Zelle verbunden ist; und
- parallel verbunden zum ersten Kondensator (CMIN) eine Reihenschaltung aus einem zweiten Kondensator (CMAX1) mit fester Kapazität und einem ersten Element (R1) mit variablem Widerstand, wobei das erste Element (R1) mit variablem Widerstand eine Steuerelektrode (G) aufweist, die mit einem Knoten (e1) zum Anlegen eines ersten logischen Eingangssignals (VIN1) der Zelle verbunden ist.

2. Logikzelle (100; 400; 600; 800) nach Anspruch 1, wobei das erste Element (R1) mit variablem Widerstand ein Element mit einer negativen Widerstandsänderung ist.

3. Logikzelle (300) nach Anspruch 1, wobei das erste Element (R1) mit variablem Widerstand ein Element mit einer positiven Widerstandsänderung ist.

4. Logikzelle (100; 300; 400; 600; 800) nach einem der Ansprüche 1 bis 3, wobei das erste Element (R1) mit variablem Widerstand ein MOS-Transistor ist.

5. Vorrichtung (100, 300, 400, 600) nach einem der Ansprüche 1 bis 3, wobei das erste Element (R1) mit variablem Widerstand ein elektromechanisches Relais ist.

6. Logikzelle (400) nach einem der Ansprüche 1 bis 5, die ferner eine parallel zum ersten Kondensator (CMIN) eine Reihenschaltung aus einem dritten Kondensator (CMAX2) und einem zweiten Element (R2) mit variablem Widerstand aufweist, wobei das zweite Element (R2) mit variablem Widerstand eine Steuerelektrode (G) aufweist, die mit einem Knoten (e2) zum Anlegen eines zweiten logischen Eingangssignals (VIN2) der Zelle verbunden ist.

7. Logikzelle (100; 300; 400; 600; 800) nach einem der Ansprüche 1 bis 6, ferner aufweisend eine kapazitive Halteschaltung (H), die zwischen dem Versorgungsknoten (a1) und dem potentialfreien Knoten (s1) der Zelle verbunden ist.

8. Logikzelle (100; 300; 400; 600; 800) nach Anspruch 7, wobei die kapazitive Halteschaltung (H) eine Reihenschaltung aus einem Kondensator (CH) und einem Element mit variablem Widerstand (RH) aufweist.

9. Logikzelle (100; 300; 400; 600; 800) nach einem der Ansprüche 1 bis 8, die ferner eine Rückstellschaltung (R) aufweist, die zwischen dem potentialfreien Knoten (s1) und einem Knoten (GND) zum Anlegen eines Referenzpotentials der Zelle verbunden ist.

10. Logikzelle (100; 300; 400; 600; 800) nach Anspruch 9, wobei die Rückstellschaltung (R) ein Element (RR) mit variablem Widerstand aufweist, das zwischen dem potentialfreien Knoten (s1) und dem Knoten (GND) zum Anlegen des Referenzpotentials der Zelle verbunden ist.

11. Logikzelle (600; 800) nach einem der Ansprüche 1 bis 10, ferner aufweisend:
- einen zusätzlichen ersten Kondensator (CMIN), der zwischen dem Knoten (a1) zum Anlegen der Versorgungsspannung (Φn) der Zelle und einem zusätzlichen potentialfreien Knoten (s1) zum Bereitstellen eines komplementären logischen Ausgangssignals (NVOUT) der Zelle verbunden ist; und
- parallel zu dem zusätzlichen ersten Kondensator (CMIN) eine Reihenschaltung aus einem zusätzlichen zweiten Kondensator (CMAX1) und einem zusätzlichen ersten Element (R1) mit variablem Widerstand, wobei das zusätzliche erste Element (R1) mit variablem Widerstand eine Steuerelektrode (G) aufweist, die mit einem Knoten (e1) zum Anlegen eines komplementären ersten Eingangslogiksignals (NVIN1) der Zelle verbunden ist,.

12. Logikzelle (600; 800) nach Anspruch 11, die ferner eine zusätzliche kapazitive Halteschaltung (H) aufweist, wobei die zusätzliche kapazitive Halteschaltung (H) eine Reihenschaltung aus einem Kondensator (CH) und einem Element (RH) mit variablem Widerstand aufweist, die zwischen dem Versorgungsknoten (a1) und dem zusätzlichen potentialfreien Knoten (s1) der Zelle verbunden ist.

13. Logikzelle (600; 800) nach Anspruch 12 in Abhängigkeit von Anspruch 8, wobei:
- das Element (RH) mit variablem Widerstand der kapazitiven Halteschaltung einen Steueranschluss (G) aufweist, der mit dem zusätzlichen potentialfreien Knoten (s1) der Zelle verbunden ist; und
- das Element (RH) mit variablem Widerstand der zusätzlichen kapazitiven Halteschaltung einen Steueranschluss (G) aufweist, der mit dem potentialfreien Knoten (s1) der Zelle verbunden ist.

14. Logikzelle (800) nach einem der Ansprüche 11 bis 13, die ferner eine zusätzliche Rückstellschaltung (R) aufweist, wobei die zusätzliche Rückstellschaltung (R) ein Element (RR) mit variablem Widerstand aufweist, das zwischen den zusätzlichen potentialfreien Knoten (s1) der Zelle und den Knoten (GND) zum Anlegen des Referenzpotentials der Zelle verbunden ist.

15. Logikzelle (800) nach Anspruch 14 in Abhängigkeit von Anspruch 10, wobei:
- das Element (RH) mit variablem Widerstand der Rückstellschaltung (R) einen Steueranschluss (G) aufweist, der mit dem zusätzlichen potentialfreien Knoten (s1) der Zelle verbunden ist; und
- das Element (RH) mit variablem Widerstand der zusätzlichen Rückstellschaltung (R) einen Steueranschluss (G) aufweist, der mit dem potentialfreien Knoten (s1) der Zelle verbunden ist.

16. Logische Schaltung aufweisend eine erste Logikzelle (100; 300; 400; 600; 800) nach einem der Ansprüche 1 bis 15 und eine zweite Logikzelle (100; 300; 400; 600; 800) nach einem der Ansprüche 1 bis 15, die in Reihe mit der ersten Zelle geschaltet ist, wobei der potentialfreie Knoten (s1) der ersten Zelle mit dem Knoten (e1) zum Anlegen des ersten logischen Eingangssignals der zweiten Zelle verbunden ist.

## Claims

1. An adiabatic logic cell (100; 300; 400; 600; 800), comprising:
- a first fixed-capacitance capacitor (CMIN) connected between an application node (a1) for applying a variable periodic supply voltage (φn) of the cell and a floating node (s1) for providing an output logic signal (VOUT) of the cell; and
- connected in parallel with the first capacitor (CMIN), an association in series of a second fixed-capacitance capacitor (CMAX1) and a first variable-resistance element (R1), the first variable-resistance element (R1) comprising a control electrode (G) connected to an application node (e1) for applying a first input logic signal (VIN1) of the cell.

2. The logic cell (100; 400; 600; 800) according to claim 1, wherein the first variable-resistance element (R1) is an element with a negative resistance variation.

3. The logic cell (300) according to claim 1, wherein the first variable-resistance element (R1) is an element with a positive resistance variation.

4. The logic cell (100; 300; 400; 600; 800) according to any of claims 1 to 3, wherein the first variable-resistance element (R1) is a MOS transistor.

5. The device (100, 300, 400, 600) according to any of claims 1 to 3, wherein the first variable-resistance element (R1) is an electromechanical relay.

6. The logic cell (400) according to any of claims 1 to 5, further comprising, connected in parallel with the first capacitor (CMIN), an association in series of a third capacitor (CMAX2) and a second variable-resistance element (R2), the second variable-resistance element (R2) comprising a control electrode (G) connected to an application node (e2) for applying a second input logic signal (VIN2) of the cell.

7. The logic cell (100; 300; 400; 600; 800) according to any of claims 1 to 6, further comprising a capacitive maintaining circuit (H) connected between the supply node (a1) and the floating node (s1) of the cell.

8. The logic cell (100; 300; 400; 600; 800) according to claim 7, wherein the capacitive maintaining circuit (H) comprises an association in series of a capacitor (CH) and a variable-resistance element (RH).

9. The logic cell (100; 300; 400; 600; 800) according to any of claims 1 to 8, further comprising a reset circuit (R) connected between the floating node (s1) and an application node (GND) for applying a reference potential of the cell.

10. The logic cell (100; 300; 400; 600; 800) according to claim 9, wherein the reset circuit (R) comprises a variable-resistance element (RR) connected between the floating node (s1) and the application node for applying a reference potential (GND) of the cell.

11. The logic cell (600; 800) according to any of claims 1 to 10, further comprising:
- an additional first capacitor (CMIN) connected between the application node (a1) for applying the supply voltage (φn) of the cell and an additional floating node (s1) for providing a complementary output logic signal (NVOUT) of the cell; and
- connected in parallel with the additional first capacitor (CMIN), an association in series of an additional second capacitor (CMAX1) and an additional first variable-resistance element (R1), the additional first variable-resistance element (R1) comprising a control electrode (G) connected to an application node (e1) for applying a complementary first input logic signal (NVIN1) of the cell.

12. The logic cell (600; 800) according to claim 11, further comprising an additional capacitive maintaining circuit (H), the additional capacitive maintaining circuit (H) comprising an association in series of a capacitor (CH) and a variable-resistance element (RH) connected between the supply node (a1) and the additional floating node (s1) of the cell.

13. The logic cell (600; 800) according to claim 12 with its dependence on claim 8, wherein:
- the variable-resistance element (RH) of the capacitive maintaining circuit has a control terminal (G) connected to the additional floating node (s1) of the cell; and
- the variable-resistance element (RH) of the additional capacitive maintaining circuit has a control terminal (G) connected to the floating node (s1) of the cell.

14. The logic cell (800) according to any of claims 11 to 13, further comprising an additional restarting circuit (R), the additional restarting circuit (R) comprising a variable-resistance element (RR) connected between the additional floating node (s1) of the cell and the application node (GND) for applying a reference potential of the cell.

15. The logic cell (800) according to claim 14 with its dependence on claim 10, wherein:
- the variable-resistance element (RH) of the restarting circuit (R) has a control terminal (G) connected to the additional floating node (s1) of the cell; and
- the variable-resistance element (RH) of the additional restarting circuit (R) has a control terminal (G) connected to the floating node (s1) of the cell.

16. A logic circuit comprising a first logic cell (100; 300; 400; 600; 800) according to any of claims 1 to 15 and a second logic cell (100; 300; 400; 600; 800) according to any of claims 1 to 15 cascaded in series with the first cell, the first cell having its floating node (s1) connected to the application node (e1) for applying the first input logic signal of the second cell.
